# EUROPEAN PATENT SPECIFICATION

(11) **EP 3 660 564 B1**
(45) Date of publication and mention of the grant of the patent: **25.01.2023**
(21) Application number: 18208885.6
(22) Date of filing: 28.11.2018
(51) Int. Cl.: G02B 6/44

(54) **CABLE MANAGEMENT SYSTEM**
KABELFÜHRUNGSSYSTEM
SYSTÈME DE GESTION DE CÂBLE

(43) Date of publication of application: 03.06.2020
(73) Proprietor: Reichle & De-Massari AG, 8620 Wetzikon (CH)
(72) Inventor: Zhelyazkov, Evgeni, 8002 Burgas (BG); Zidarova, Nadejda, 1111 Sofia (BG); Franzke, Jörg, 8623 Wetzikon (CH); Lendi, Christian, 8625 Gossau (CH)
(74) Representative: Daub, Thomas

(56) References cited:
- EP-A1- 2 400 327
- US-A1- 2006 018 622
- US-A1- 2010 296 790
- US-A1- 2017 192 191
- US-B1- 6 556 761

## Description

### State of the art

The invention relates to a cable management system according to the preamble of claim 1 and a method for assembling a cable management device according to claim 17.

From the state of the art cable management systems with cable management devices for cables, in particular patch cables, in particular for optical waveguide cables, are known. The cable management devices comprise a cable management unit embodied as a 19-inch insert for connecting to a 19 inch standard rack, wherein the cable management units comprise at least one drawer unit which is movable from a storage position to a process position and vice versa.

EP2400327 discloses a cable management system allowing for flexibility in the mounting orientation of a rear cable manager.

The objective of the invention is, in particular, to provide a cable management system with improved characteristics regarding flexibility. The objective is achieved, according to the invention, by the features of claims 1 and 17, while advantageous implementations and further developments of the invention may be gathered from the dependent claims.

### Advantages of the invention

In one aspect of the invention, which may in particular be considered in combination with as well as separately from other aspects of the invention, a cable management system is proposed, comprising: at least one cable management unit which has at least one receiving space for receiving at least one drawer unit, wherein the cable management unit comprises at least one rear cable manager which is configured to feed at least one cable to a rear side of the receiving space and which is mountable in at least two different orientations with respect to the receiving space and in particular to the frame unit.

In another aspect of the invention, which may in particular be considered in combination with as well as separately from other aspects of the invention, a cable management system, in particular the aforementioned cable management system, is proposed comprising: at least one cable management unit, in particular the aforementioned cable management unit, which has at least one receiving space for receiving at least one drawer unit, in particular the aforementioned drawer unit,; the drawer unit; and at least one further drawer unit differing from the drawer unit in at least one geometrical parameter and fitting into the receiving space.

By means of the invention in particular an enhanced flexibility can be achieved. In particular a flexible cable management can be achieved. In particular, a compact embodiment can be achieved. In this regard, an advantageously flexibly usable and/or adaptable cable management device can be made available. Moreover, an efficiency, in particular a construction space efficiency, a performance efficiency, a component efficiency and/or a cost efficiency, may be improved advantageously. In particular a flexibility regarding a construction space and/or installation can be achieved. Advantageously, cost reduction effects can be achieved in particular by interchangeable components of the rear cable manager.

A "cable management system" is to be understood, in this context, in particular as a modular construction system, which comprises a certain number of elements to build preferably in a modular way a unit or device which is configured to execute at least one function in at least one operational state.

Moreover, a "cable management unit" is in particular to be understood as a unit which is in particular, in at least one operational state, configured for managing, in particular guiding, connecting, coupling, terminating and/or distributing, cables, in particular patch cables, in particular a plurality of cables, in particular a plurality of patch cables, preferably optical waveguide cables. In particular, the cable management unit comprises at least one frame unit, in particular a chassis and/or an exterior housing, which can preferably be fastened to the carrier unit and which is configured to at least partly and preferably at least largely delimit at least one receiving space for receiving at least one drawer unit and/or at least one further drawer unit and preferably a plurality of drawer units and/or further drawer units, in particular at least two, preferably at least three and most preferably at least six drawer units and/or further drawer units. Preferably the frame unit is configured for receiving up to six drawer units and/or further drawer units wherein each of the drawer units and/or further drawer units received in the frame unit is preferably individually movable, in particular with respect to any other drawer unit and/or further drawer unit and in particular with respect to the frame unit, from a storage position to at least one process position and advantageously to at least two different process positions and vice versa. This allows achieving a particularly flexible cable management, in particular without affecting other drawer units and/or further drawer units during movement of one drawer unit and/or further drawer unit. Furthermore, handling can be simplified as the frame unit can be advantageously handled as a single structural unit.

Moreover, the cable management unit could be embodied, for example, as an ETSI insert in particular with a standard width of 535 mm, as a 23-inch insert and/or as any other insert, in particular for connecting to an, in particular standard, ETSI rack, 23-inch rack and/or any other rack. It is, however, advantageously proposed that the cable management unit is embodied as a 19-inch insert, in particular for connecting to an, in particular standard, 19-inch rack. Furthermore, the cable management unit could, in particular, have a height between 1 height unit and 5 height units. However, preferably the cable management unit has a height of 1 height unit. The cable management unit could be embodied, for example, as an ETSI insert, as a 23-inch insert and/or as any other suitable insert. However, it is proposed that the cable management unit is advantageously embodied as a 19-inch insert and is configured to support at least 144 fiber connections, in particular at least 144 LC simplex port connections whereby each two LC simplex port connections can be used as one LC double port connection, per height unit. Preferably, a port density of the cable management unit is 144 port connections per one height unit. In this way in particular a cable management device with an improved flexibility may be provided wherein the cable management device may in particular be individually adapted to different needs of users.

Furthermore, a "drawer unit" and/or a "further drawer unit" is in particular to be understood as an, in particular movably mounted, unit which is located in a storage position in particular in the receiving space and which is preferably configured for providing and/or supporting a connection functionality and/or a connection capability. Herein, the drawer unit and/or the further drawer unit is preferably configured for guiding, connecting, coupling, terminating and/or distributing at least one cable. Advantageously, the drawer unit and/or the further drawer unit extend at least largely over a half width of the cable management unit. In particular in the storage position the drawer unit and/or further drawer unit are arranged at least substantially in a same plane in a side by side position. In addition, drawer unit and/or the further drawer unit could in particular have a height between 10 % and 80 %, preferably between 15 % and 60 % and particularly preferably between 20 % and 40 %, of a height of the cable management unit. However, preferably the drawer unit and/or the further drawer unit has a height of 33 % of a height of the cable management unit. Particularly preferably, the cable management unit comprises a plurality, preferably at least one, particularly preferably at least three and most preferably at least six, drawer units and/or further drawer units which are preferably releasable from, connectable to and/or replaceable by each other individually and which can be at least largely embodied at least substantially identical to each other. In addition, the drawer units and/or the further drawer units are preferably located in particular in two columns adjacent to each other and in three rows particularly preferably one above the other. The drawer unit and/or the further drawer unit have in particular each a modular structure and are preferably movable from at least one storage position to at least one process position and vice versa, preferably in a linear motion. By the expression "having a modular structure" is herein to be understood, in particular, that the drawer unit and/or the further drawer unit itself and/or at least one structural component of the drawer unit and/or the further drawer unit has a modular structure and/or is implemented in such a way that it can be assembled modularly, for example like in a construction kit. In particular, herein at least one structural component of the drawer unit and/or the further drawer unit can be replaced by at least one further structural component. Particularly preferably, the drawer unit and/or the further drawer unit are herein extendable and/or reducible in any required way.

Furthermore, by a "storage position" is to be understood, in particular, an in particular mechanically defined position, in particular with respect to the frame unit, of the drawer unit and/or the further drawer unit, in which a normal operation takes place and/or in which a processing, e.g. a maintenance, a new cabling, a patching and/or a splicing, is limited to a large extent. In particular, in the storage position the drawer unit and/or the further drawer unit is at least largely and preferably completely located in the receiving space of the cable management unit and/or at least largely and preferably completely inserted into the cable management unit. By a "process position" is to be understood, in particular, an in particular mechanically defined position, in particular with respect to the frame unit, of the drawer unit and/or the further drawer unit, in which a processing operation, e.g. a maintenance operation, a cabling operation, a patching operation and/or a splicing operation, is possible. In particular, in the process position the drawer unit is only partly located in the receiving space of the cable management unit and/or only partly inserted into the cable management unit.

A "geometrical parameter" of a unit is to be understood, in this context, in particular as a structural feature of the unit e.g. a number of compartments of the unit, as a one feature of geometric dimensions such as length, volume, height and/or width. The geometrical structure could additionally or alternatively be a surface structure and/or connecting structure of the unit for connection with at least one further unit. In particular the drawer unit and the further drawer unit comprise a different number of compartments.

Furthermore, a cable management device is proposed, for an assembly of which the cable management system according to the invention is used. A "cable management device" is to be understood, in this context, in particular at least as a device, preferably for use in a fiber optic network, in particular a data center. In particular, the cable management device is configured for terminating at least one cable and preferably a plurality of cables, in particular patch cables and/or for supporting an interconnection between a plurality of cables, in particular patch cables. Herein, the cable management device is preferably embodied as an optical distribution frame. Moreover, the cable management system and/or the cable management device may in particular also comprise at least one cable, preferably optical waveguide cable, and/or at least one carrier unit, which may preferably be embodied as a rack and which is in particular configured for fastening the cable management unit at least indirectly and/or directly. "Configured" is in particular to mean specifically designed and/or equipped. By an object being configured for a certain function, it is in particular to be understood that the object fulfills and/or implements this certain function in at least one application state and/or operating state. Advantageously, the cable management device comprises a plurality, preferably at least four, particularly preferably at least eight and most preferably at least fourteen, cable management units which are preferably releasable from, connectable to and/or replaceable by each other individually and which are embodied particularly preferably at least substantially identical to each other. Herein, the cable management units are preferably located adjacent to each other and particularly preferably one above the other, in particular with respect to a height of the cable management unit. The term "at least substantially" is in particular to be understood as a deviation from a value of maximally 15 %, in particular of maximally 10 %, advantageously of maximally 5 %, particularly advantageously of maximally 3 % and preferably of maximally 1 %. The phrasing "at least substantially identical objects" is in particular to mean, in this context, objects which advantageously have the same structure but may at least partially differ in particular as regards their functionality, their inner structure, and/or their dimensions. However, preferably the at least substantially identical objects are identical aside from manufacturing tolerances and/or within the range of standardized tolerances. One "height unit" herein corresponds in particular to one rack unit (U) and/or 44.45 mm. The term "at least largely" is herein to mean, in particular, by at least 55 %, advantageously by at least 65 %, preferably by at least 75 %, particularly preferentially by at least 85 % and especially advantageously by at least 95 %.

In particular, the rear cable manager comprises at least one rear bracket for rear cabling procedure and/or at least one side bracket, preferably two side brackets, for side cabling procedure. The rear bracket and/or the side brackets are in particular configured to provide at least one mounting surface for fixing elements to fixate at least one object, for example in particular an electrical and/or optical cable, a tube, a cable fanout and/or a cable divider. Preferably, the rear bracket is mountable at at least two mounting positions over and under a main extension plane of the cable management unit. By a "main extension plane" of an object is in particular a plane to be understood which is oriented parallel to a largest side surface of a smallest imaginary rectangular cuboid which just still completely encloses the object, and in particular runs through the center of the rectangular cuboid. In particular the rear cable manager is a part of the frame unit. In particular the rear cable manager has a modular structure.

In particular, the side bracket is mountable at at least four mounting positions. In particular the side bracket comprises mounting surface, the mounting surface in the assembled state being at least substantially parallel to the main extension plane of the cable management unit, is extending in a first position at least largely into a smallest imaginary rectangular cuboid which just still completely encloses the cable management unit. In a second position the side bracket is rotated about 180 ° around an first axis which is perpendicular to the main extension plane of the cable management unit and runs through the side bracket whereby the mounting surface of the side bracket is extending at least largely away from the inner part of the smallest imaginary rectangular cuboid which just still completely encloses the cable management unit. In a third position the side bracket is rotated about 180 ° in regard to the first position around a second axis which is parallel to the main extension direction of the cable management unit and runs through the side bracket whereby the mounting surface of the side bracket is extending at least largely away from the inner part of the smallest imaginary rectangular cuboid which just still completely encloses the cable management unit. In a fourth position the side bracket is rotated about 180 ° in regard to the third position around the first axis whereby the mounting surface of the side bracket is extending at least largely into the inner part of the smallest imaginary rectangular cuboid which just still completely encloses the cable management unit.

Furthermore, it is proposed that the drawer unit has a base 8 configuration. By a "base 8 configuration" of an object is in particular a configuration of the object to be understood, in which in particular most of exchangeable units are connectable with the object, preferably all exchangeable units, comprise 8 fiber connections, in particular 8 LC simplex connections or 4 LC duplex connections. Thereby, in particular a possibility of creation of a plurality of connections, in particular of LC simplex connections can be provided.

Additionally, it is proposed that the drawer unit is configured to support in particular at least three individually exchangeable, in particular at least substantially identical, adapter inlays. In this way, in particular an improved flexibility may be achieved. Moreover, an improved maintainability can be achieved. The phrasing "at least substantially identical objects" is in particular to mean, in this context, objects which advantageously have the same structure but may at least partially differ in particular as regards their functionality, their inner structure, and/or their design and/or arrangement of a connection side of the object. However, preferably the at least substantially identical objects are identical aside from manufacturing tolerances and/or within the range of standardized tolerances. The drawer unit with the base 8 configuration comprises in particular at least one connection interface configured to support at least one adapter inlay, preferably base 8 adapter inlay, preferably up to three base 8 adapter inlays and/or to connect the drawer unit with at least one adapter inlay, preferably base 8 adapter inlay, preferably with up to three base 8 adapter inlays. In particular the adapter inlay connection surface supports the adapter inlay in the assembled state by means of a force-fit connection and/or by means of a form-fit connection. The base 8 adapter inlays comprise in particular 8 fiber connections, preferably 8 LC simplex connections. In an assembled state of the cable management unit with at least two base 8 adapter inlays the base 8 adapter inlays are arranged adjacent to each other, while respective main extension planes of respective base 8 adapter inlays are at least substantially parallel to each other and/or are arranged in one same plane, preferably at least substantially parallel to a main extensions plane of the drawer unit. In particular a main extension direction of the base 8 adapter inlay is in at least one assembled state at least substantially parallel to a main extension direction of the drawer unit. By a "main extension direction" of an object is in particular a direction to be understood which is oriented parallel to a longest edge of a smallest imaginary rectangular cuboid which just still completely encloses the object. By a "assembled state" of an object is in particular a state of the object to be understood, in which the object is in a fully functional state and comprises all necessary elements which are connected and/or assembled as a unit so the object is ready to perform at least one intended function and/or task.

It is further proposed, that the further drawer unit has a base 12 configuration. By a "base 12 configuration" of an object is in particular a configuration of the object to be understood, in which in particular most of exchangeable units connectable with the object, preferably all exchangeable units, comprise 12 fiber connections, in particular 12 LC simplex connections or 6 LC duplex connections. Thereby, in particular a possibility of creation of a plurality of connections, in particular of LC simplex connections can be provided.

Additionally, it is proposed that the further drawer unit is configured to support in particular at least two individually exchangeable, in particular at least substantially identical, further adapter inlays. In this way, in particular, an improved flexibility may be achieved. Moreover, an improved maintainability can be achieved. The further drawer unit with the base 12 configuration comprises in particular at least one further connection interface configured to support at least one further adapter inlay, preferably base 12 further adapter inlay, preferably up to two base 12 further adapter inlays and/or to connect the further drawer unit with at least one further adapter inlay, preferably base 12 further adapter inlay, preferably with up to two base 12 further adapter inlays. In particular the further adapter inlay connection surface supports the further adapter inlay in the assembled state by means of a force-fit connection and/or by means of a form-fit connection. The base 12 further adapter inlays comprise in particular 12 fiber connections, preferably 12 LC simplex connections. In an assembled state of the cable management unit with at least two base 12 further adapter inlays the base 12 further adapter inlays are arranged adjacent to each other, while respective main extension planes of respective base 12 further adapter inlays are at least substantially parallel to each other and/or are arranged in one same plane, preferably at least substantially parallel to a main extension plane of the further drawer unit. In particular a main extension direction of the base 12 further adapter inlay is in at least one assembled state at least substantially parallel to a main extension direction of the further drawer unit.

Advantageously, it is further proposed that the adapter inlay and/or the further adapter inlay and a part of the drawer unit and/or of the further drawer unit implement at least partly a protective housing for at least one further unit. The further unit may in particular comprise at least one electronic component and/or a part of the at least one electronic component such as cable, in particular as a patch cable, fiber connections, switches and/or microelectronic components. The protective housing may provide a protection against water ingress and be in particular fully waterproof and/or provide at least one dust protection and/or provide at least partly an electromagnetic shielding and/or provide a protection against mechanical damage. The protective housing may comprise at least one protective element such as seal, metal lattice and/or mechanically durable elements. In this way, in particular damages, in particular by a mechanical force or by a water ingress, at least of a part of cables, in particular patch cables, of cable connections and/or of electronic components in particular inside the drawer unit and/or the further drawer unit can be minimized and/or avoided. Furthermore, in this way in particular an electromagnetic shielding can be provided. Thereby, in particular an enhanced performance can be achieved.

Furthermore is proposed that the cable management system comprises at least one sensor unit, which has a plurality of sensors configured for detecting at least one connection state and which is arrangeable likewise on the drawer unit and the further drawer unit. In this way in particular an advantageous control and/or monitoring of the connections state can be achieved and as a result in particular an improved maintainability and/or a connection or patching process may be accomplished. In particular the sensor unit is compatible with both the drawer unit and the further drawer unit. Moreover, in this way a flexibility in an operational state and/or a cost efficiency, may be improved advantageously. In particular the sensor unit is releasably connectable with the drawer unit and/or with the further drawer unit. Preferably the sensors are implemented as a RFID-sensor, in particular as a RFID-antenna. The sensor unit comprises in particular at least 8 sensors, preferably at least 12 sensors. In particular, the sensor unit is connectible with the drawer unit and the further drawer unit by means of a force-fit connection and/or by means of a form-fit connection. Preferably a main extension direction of the sensor unit in at least one assembled state is oriented at least substantially perpendicularly to the main extension direction of the drawer unit and/or the further drawer unit. Preferably a main extension plane of the sensor unit in at least one assembled state is oriented at least substantially parallel to the main extension plane of the drawer unit and/or the further drawer unit.

It is moreover proposed that the cable management unit comprises at least one slide contact configured to electrically connect, preferably wireless, the sensor unit in at least one storage position of the drawer unit and/or the further drawer unit and in at least one process position of the drawer unit and/or the further drawer unit in particular with one control unit. In particular the sensor unit comprises a corresponding slide contact which cooperates with the slide contact, whereby the corresponding slide contact is arranged on a lateral part of the drawer unit and/or the further drawer unit. In particular the slide contact is arranged on the frame unit and is electrically connectible with the corresponding slide contact. As a result, in particular a facilitated installation and/or assembly of the cable management unit can be achieved. Moreover, in particular an operation and/or maintainability may be simplified. Preferably the cable management unit comprises two slide contacts and the sensor unit comprises two corresponding slide contacts. In the storage position and/or process position the slide contact and the corresponding slide contact form one slide contact pair whereby the pair is arranged in at least one assembled state lateral on one side of the drawer unit and/or the further drawer unit.

Furthermore, it is proposed that the drawer unit and/or the further drawer unit comprise/comprises a front top cover unit, which is located in a front area of the cable management unit and is configured to in particular mechanically protect at least one cable from above and/or locates the at least one cable in a defined position. In this way, in particular a durability of an error-free operation of the cable management unit, in particular by prevention of mechanical damages of cables, in particular patch cables and/or connections, can be achieved. The expressions "above", "under", "front", "rear", "side", "left", "right", "top", "bottom" are in particular to be understood in respect to an orientation of the cable management unit and/or the drawer unit and/or the further drawer unit in the operational state and/or storage position and/or process position. The front top cover unit is in particular releasably connectable with the drawer unit and/or the further drawer unit and in particular is arrangeable likewise on the drawer unit and the further drawer unit. In particular, the front top cover unit is connectible with the drawer unit and the further drawer unit by means of a force-fit connection and/or by means of a form-fit connection. Preferably a main extension direction of the front top cover unit in at least one assembled state is oriented at least substantially parallel to the main extension direction of the sensor unit. Preferably a main extension plane of the front top cover unit in at least one assembled state is oriented at least substantially parallel to the main extension plane of the sensor unit.

Advantageously, it is further proposed that the front top cover unit comprises a bi-stable living hinge. Preferably, when viewed form the front side of the drawer unit and/or further drawer unit, the bi-stable living hinge is situated on a left or right side of the front top cover unit. The bi-stable living hinge provides at least a first and a second at least substantially stable position of the front top cover unit whereby in the first position the front top cover unit has a protective function and in the second position the front top cover unit allows in particular a maintenance work and/or an exchange of the cables, in particular patch cables and/or connecting and/or disconnecting of the connections with the drawer unit and/or further drawer unit.

Advantageously, it is further proposed that the front top cover unit comprises at least one labelling surface. Thereby, in particular information can be additionally provided for a user and/or service engineer whereby a simplification of a maintenance process and/or improvement of safety aspects in particular during a maintenance procedure may be achieved. In particular the labelling surface can be repeatedly labeled. The labelling surface can be labeled manually e.g. by a pen and/or labeled by a color label and/or by an electronic or electronically detectible label.

It is moreover proposed that the cable management unit comprises at least one front cover unit that is configured for covering the receiving space in a forward direction and has at least one telescopic hinge, in particular two telescopic hinges, and in particular at least one cover element. The telescopic hinge connects in particular the cover element with the frame unit. In particular the telescopic hinge transfers the cover element from a first, in particular closed, state in which the cover element covers the receiving space and in particular in the receiving space arranged drawer unit and/or further drawer unit into a second, in particular opened, state by at least one rotatory and at least one translatory movement and vice versa. Preferably a main extension direction of the cover element in at least one assembled state is oriented at least substantially parallel to the main extension direction of the sensor unit and/or of the front top cover unit. Preferably a main extension plane of the cover element rotates during a movement from the first into the second state and vice versa about an axis which is oriented at least substantially parallel to the main extension plane of the of the cable management unit and/or parallel to the main extension direction of the sensor unit and/or of the front top cover unit. Preferably the front cover unit covers the whole receiving space in particular with the drawer unit and/or the further drawer unit at the same time. As a result, in particular a safe storage of the drawer unit and/or further drawer unit in particular in the operational state may be achieved. Additionally, in particular mechanical damages in particular of the drawer unit and/or further drawer unit in particular in the storage position may be prevented.

Additionally, it is proposed that the drawer unit and/or the further drawer unit comprises/ comprise at least one cable divider element which in an assembled state defines at least two cable guiding channels and is positioned left and right in a front area of the cable management unit respectively. Preferably the drawer unit and/or the further drawer unit each comprises/comprise two cable divider elements. Thereby, in particular a tidy and/or clear arrangement of cables, in particular patch cables, in the front area of the drawer unit and/or the further drawer unit can be attained which may lead in particular to an improved maintainability and hence preferably to a lower error-proneness during a connecting process of cables, in particular patch cables. Preferably the cable guiding channels are configured to collect and divide the cables, in particular patch cables, into at least two at least partly separate bundles.

It is further proposed that the cable management unit comprises a locking unit configured to lock the drawer unit and/or the further drawer unit at least in a storage position and/or in a process position. As a result, in particular a safe positioning of the drawer unit and/or the further drawer unit, in particular in storage position and/or process position of the drawer unit and/or the further drawer unit can be achieved. In particular the locking unit comprises, preferably for each drawer unit and/or further drawer unit at least one locking catch and at least one lever which is connected to the locking catch and configured to lock and unlock the drawer unit and/or the further drawer unit at least in a storage position and/or in a process position

In another aspect of the invention, which may in particular be considered in combination with as well as separately from other aspects of the invention, a method is proposed for assembling a cable management device, wherein the cable management system is used to assemble the cable management device. Thereby an enhanced flexibility can be achieved.

Herein the cable management system and the cable management are not to be limited to the application and implementation described above. In particular, for the purpose of fulfilling a functionality herein described, the cable management system may comprise a number of respective elements, structural components and units that differs from the number mentioned herein. Furthermore, regarding the value ranges mentioned in this disclosure, values within the limits mentioned are to be understood to be also disclosed and to be used as applicable.

### Drawings

Further advantages may become apparent from the following description of the drawings. In the drawings exemplary embodiments of the invention are shown. The drawings, the description and the claims contain a plurality of features in combination. The person having ordinary skill in the art will purposefully also consider the features separately and will find further expedient combinations.

If there is more than one specimen of a certain object, only one of these is given a reference numeral in the figures and in the description. The description of this specimen may be correspondingly transferred to the other specimens of the object.

It is shown in:
- Fig. 1: a schematic view of an exemplary cable management device which is assembled by using a cable management system having a plurality of cable management units, drawer units and further drawer units,
- Fig. 2: a perspective view of one cable management unit having a rear cable manager with one further drawer unit which is arranged in a receiving place of the cable management unit,
- Fig. 3: a perspective top view of the drawer unit,
- Fig. 4: a perspective top view of the further drawer unit,
- Fig. 5: a perspective bottom view of the drawer unit,
- Fig. 6: a perspective bottom view of the further drawer unit, and
- Fig. 7: a diagram of a method for assembling the cable management device.

### Description of the exemplary embodiment

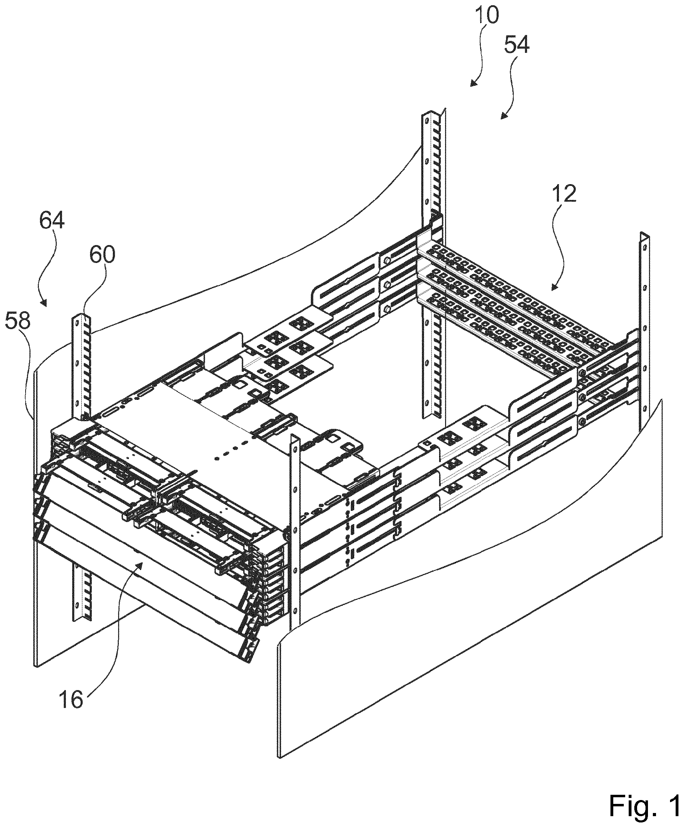

Figure 1 schematically shows a cable management device 54 which is implemented by assembly from a cable management system 10.

The cable management device 54 is implemented as a network cabinet 58 with a rack 60. The cable management device 54 is configured for managing cables 62, which can be embodied as optical waveguide cables. However, it is also conceivable to use cables 62 that differ from optical waveguide cables, e.g. electric cables.

The cable management system 10 comprises at least one cable management unit 12. In the present case, the cable management device 54 comprises a plurality of cable management units 12, in particular three cable management units 12, wherein for the sake of clarity in figure 1 only one of the cable management units 12 comprises a reference numeral.

The cable management units 12 are located adjacent to each other. The cable management units 12 are located one above the other. The cable management units 12 are at least substantially identical to each other. Moreover, the cable management units 12 are releasable from, connectable to and/or replaceable with each other individually.

The following description will be restricted to one of the cable management units 12, wherein, due to the at least substantially identical construction of the cable management units 12, the following description may also apply to possible other cable management units 12.

The cable management unit 12 is in the present case embodied as a 19-inch insert. The cable management unit 12 is intended to be used in a carrier unit 64, in the present case in particular in a rack 60. Herein, the cable management unit 12 is installed horizontally.

The cable management unit 12 has a height of one height unit (U).The cable management unit 12 comprises a fiber connection density of 144 connections per height unit (U).

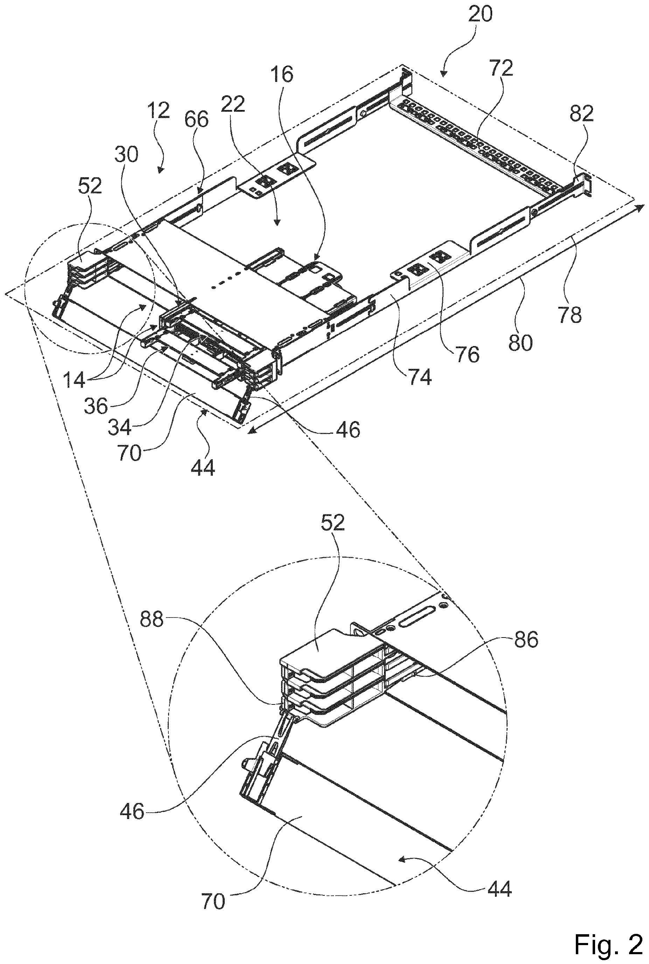

Figure 2 shows a perspective view of one cable management unit 12 having a rear cable manager 20 with one further drawer unit 18. The further drawing unit 18 is arranged in a receiving place 14 of the cable management unit 12.

The cable management unit 12 comprises a frame unit 66 (cf. figures 1 and 2). The frame unit 66 is embodied as a chassis. The frame unit 66 forms an outer housing of the cable management unit 12. The frame unit 66 is in the present case made of metal, in particular metal sheets. Alternatively, a frame unit 66 may be made at least partly of a plastic material.

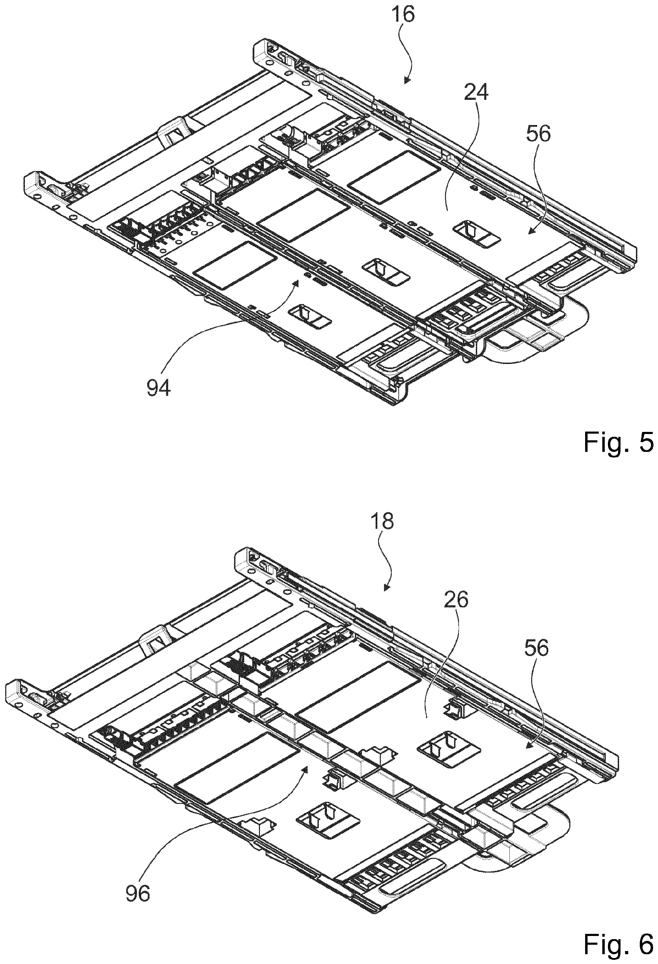

The cable management system 10 comprises in the present case a drawer unit 16. The cable management system 10 comprises one further drawer unit 18. The further drawer unit 18 differs from the drawer unit 16 in at least one geometrical parameter (cf. figure 5 and 6). The geometrical parameter is a connection interface 94.

The cable management unit 12 has six receiving spaces 14. The six receiving spaces 14 are arranged in two columns besides each other. The frame unit 66 defines and/or delimits the receiving spaces 14. The receiving space 14 is configured for receiving one drawer unit 16 or one further drawer unit 18. The receiving spaces 14 have the same dimensions. The drawer unit 16 fits into the receiving space 14. The further drawer unit 18 fits into the receiving space 14.

In the present case three drawer units 16 are placed one above each other in a stack (cf. figure 2). One drawer unit 16 is in the process position 36. One drawer unit 16 at the top of the stack and one drawer unit 16 at the bottom of the stack are in the storage position 34.

The frame unit 66 is configured for receiving up to six drawer units 16 or up to six further drawing units 18 or up to six drawer units 16 and one further drawer unit 18.The drawer units 16 and/or the further drawer units 18 received in the frame unit 66 are positioned in a storage position 34. The drawer units 16 and/or the further drawer units 18 received in the frame unit 66 are positioned over and/or besides each other.

The drawer units 16 and/or the further drawer units 18 received in the frame unit 66 are movable from the storage position 34 to at least one process position 36 and vice versa. The drawer units 16 and/or the further drawer units 18 are movable in a linear motion with respect to the frame unit 66. Each of the drawer units 16 and/or the further drawer units 18 is individually movable with respect to any other drawer unit 16 and/or the further drawer units 18. Each of the drawer units 16 and/or the further drawer units 18 is individually movable with respect to the frame unit 66, from a storage position 34 (cf. figure 1) to the process position 36 and vice versa.

The cable management unit 12 comprises a front cover unit 44. The front cover unit 44 is configured for covering the receiving spaces 14 in a forward direction.

The front cover unit 44 has two telescopic hinges 46. The front cover unit 44 has a cover element 70. The telescopic hinge 46 connects the cover element 70 with the frame unit 66. The telescopic hinge 46 transfers the cover element 70 from a first, closed state of the front cover unit 44 into a second, opened state by a rotatory and a translatory movement and vice versa. In the closed state the cover element 70 covers all six receiving spaces 14.

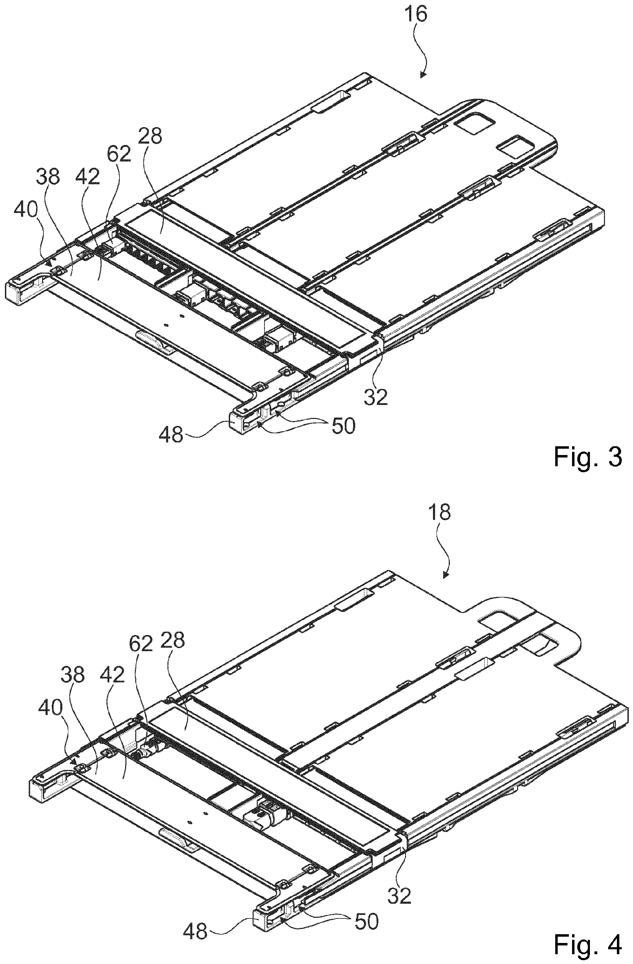

A main extension direction of the cover element 70 in an assembled state is oriented parallel to a main extension direction of a sensor unit 28 of the cable management unit 12 and/or of a front top cover unit 38 of the cable management unit 12 (cf. figures 3 and 4). A main extension plane of the cover element 70 rotates during the movement from the closed into the opened state and vice versa about an axis which is oriented parallel to the main extension plane of the cable management unit 12 and/or parallel to the main extension direction of the sensor unit 28 and/or of the front top cover unit 38. The front cover unit 44 covers all the receiving spaces 14 at the same time.

The cable management unit 12 comprises one rear cable manager 20. The rear cable manager 20 is configured to feed at least one cable to a rear side 22 of the receiving space 14. The rear cable manager 20 is a part of the frame unit 66. The rear cable manager 20 has a modular structure.

The rear cable manager 20 comprises one rear bracket 72 for a rear cabling procedure. The rear cable manager 20 comprises two side brackets 74 for a side cabling procedure. The rear bracket 72 and/or the side brackets 74 are configured to provide at least one mounting surface for fixing elements to fix at least one object, for example an electrical and/or optical cable, a tube, a cable fanout and/or a cable divider.

The rear bracket 72 is mountable at two mounting positions over and under a main extension plane of the cable management unit 12. The rear bracket 72 comprises a perforation for fixing elements.

The following description will be restricted to one of the side brackets 74, wherein, due to the at least substantially identical construction of the side brackets 74, the following description may also apply to other side brackets 74.

The side bracket 74 comprises a mounting surface 76. The mounting surface 76 is parallel to a main extension plane 78 of the cable management unit 12. The mounting surface 76 comprises a perforation for fixing elements.

The side bracket 74 is mountable at four mounting positions. The mounting surface 76 is arranged in a first position. The mounting surface 76 extends into a smallest imaginary rectangular cuboid which just still completely encloses the cable management unit.

The rear cable manager 20 comprises mounting elements 82 for mounting the cable management unit 12 on the rack 60.

The cable management unit 12 comprises a locking unit 52. The locking unit 52 is configured to lock the drawer unit 16 and the further drawer unit 18 in the storage position 34. The locking unit 52 is configured to lock the drawer unit 16 and the further drawer unit 18 in the process position 36. The locking unit 52 is arranged in the front lateral area of the cable management unit 12.

The locking unit 52 comprises for each drawer unit 16 and/or further drawer unit 18 a locking catch 86. The locking unit 52 comprises for each drawer unit 16 and/or further drawer unit a lever 88. The lever 88 is connected to the locking catch 86. The lever 88 and the locking catch 86 are configured to lock and unlock the drawer unit 16 and/or the further drawer unit 18 in a storage position 34 and/or in a process position 36.

The cable management system comprises a sensor unit 28 (cf. figures 3 and 4). The sensor unit 28 has a plurality of sensors. The sensor unit 28 comprises at least 12 sensors.

The sensor is implemented as a RFID-sensor, in particular as a RFID-antenna. The sensors are configured for detecting at least one connection state.

Figure 3 shows a perspective top view of the drawer unit 16. Figure 4 shows a perspective top view of the further drawer unit 18. The sensor unit 28 is releasably connected with the drawer unit 16. The sensor unit 28 is releasably connected with the further drawer unit 18. The sensor unit 28 is compatible with both the drawer unit 16 and the further drawer unit 18. The sensor unit 28 is arrangeable likewise on the drawer unit 16 and the further drawer unit 18.

The sensor unit 28 is connected with the drawer unit 16 by means of a force-fit connection and/or by means of a form-fit connection. The sensor unit 28 is connected with the further drawer unit 18 by means of a force-fit connection and/or by means of a form-fit connection.

A main extension direction of the sensor unit 28 is oriented perpendicularly to a main extension direction of the drawer unit 16 and/or the further drawer unit 18. A main extension plane of the sensor unit 28 is oriented parallel to the main extension plane of the drawer unit 16 and/or the further drawer unit 18.

The cable management unit 12 comprises two slide contacts 30. The slide contacts 30 are configured to electrically connect the sensor unit 28 in the storage position 34 of the drawer unit 16 and/or the further drawer unit 18 and in the process position 36 of the drawer unit 16 and/or the further drawer unit 18. In particular the slide contacts 30 are arranged on the frame unit 66.

The sensor unit 28 comprises a corresponding slide contact 32. The corresponding slide contact 32 cooperates with the slide contact 30. The slide contact 30 is electrically connectible with the corresponding slide contact 32. The slide contact 30 establishes a wireless electrical connection with the corresponding slide contact 32. The corresponding slide contact 32 is connected with a control unit which is configured to monitor and/or control a connected state. The corresponding slide contact 32 is arranged in the assembled state on a lateral part of the drawer unit 16 and/or the further drawer unit 18.

The sensor unit 28 comprises two corresponding slide contacts 32 so that the drawer unit 16 and/or the further drawer unit 18 can be arranged in every receiving space 14. In the storage position 34 and the process position 36 the slide contact 30 and the corresponding slide contact 32 form one wireless electrically connected pair.

The drawer unit 16 and the further drawer unit 18 comprise each a front top cover unit 38. The front top cover unit 38 is located in a front area of the cable management unit 12. The front top cover unit 38 is configured to protect at least one cable 62 from above.

The front top cover unit 38 is releasably connected with the drawer unit 16. The front top cover unit 38 is releasably connected with the further drawer unit 18. The front top cover unit 38 is compatible with both the drawer unit 16 and the further drawer unit 18. The front top cover unit 38 is arrangeable likewise on the drawer unit 16 and the further drawer unit 18.

The front top cover unit 38 is connected with the drawer unit 16 by means of a force-fit connection and/or by means of a form-fit connection. The front top cover unit 38 is connected with the further drawer unit 18 by means of a force-fit connection and/or by means of a form-fit connection.

The front top cover unit 38 comprises a bi-stable living hinge 40. When viewed from the front side of the drawer unit 16 and/or further drawer unit 18, the bi-stable living hinge 40 is situated on a left or right side of the front top cover unit 38. The bi-stable living hinge 40 provides a first and a second stable position of the front top cover unit 38. The front top cover unit 38 is in the first position. In the first position the front top cover unit 38 has a protective function. The front top cover unit 38 limits a freedom of movement of cables.

A main extension direction of the front top cover unit 38 in the assembled state is oriented parallel to the main extension direction of the sensor unit 28. A main extension plane of the front top cover unit 38 in the assembled state is oriented parallel to the main extension plane of the sensor unit 28.

The front top cover unit 38 comprises a labelling surface 42. The labelling surface 42 can be repeatedly labeled. The labelling surface 42 can be labeled manually e.g. by a pen and/or labeled by a color label and/or by an electronic or electronically detectible label.

The drawer unit 16 and/or the further drawer unit 18 comprise/comprises two cable divider elements 48. The cable divider elements 48 define two cable guiding channels 50. The cable divider elements 48 are positioned in a front area of the cable management unit 12.

The cable guiding channel 50 is configured to collect and divide the cables into two at least partly separate bundles.

Figure 5 shows a perspective bottom view of the drawer unit 16. The drawer unit 16 has a base 8 configuration.

The drawer unit 16 is configured to support three individually exchangeable adapter inlays 24. The adapter inlays 24 have identical dimensions aside from manufacturing tolerances and/or within the range of standardized tolerances.

The drawer unit 16 with the base 8 configuration comprises one connection interface 94. The connection interface 94 is configured to support three base 8 adapter inlays 24. The connection interface 94 is configured to connect the drawer unit 16 with the three base 8 adapter inlays 24. The connection surface 94 supports the base 8 adapter inlays 24 in the assembled state by means of a force-fit connection and/or by means of a form-fit connection. One base 8 adapter inlay 24 comprises eight LC simplex connections. Two base 8 adapter inlays 24 comprise four LC duplex connections. It is conceivable that the base 8 adapter inlay 24 comprises at least one SC connection and/or at least one MPO connection. It is conceivable that the base 8 adapter inlay 24 comprises connections for a different kind of patch cables.

In the assembled state of the cable management unit 12 the base 8 adapter inlays 24 are arranged adjacent to each other. Respective main extension planes of respective base 8 adapter inlays 24 are parallel to each other and/or the main extension planes of the base 8 adapter inlays 24 are arranged in one same plane. Respective main extension planes of respective base 8 adapter inlays 24 are parallel to the main extensions plane of the drawer unit 18. A main extension direction of the base 8 adapter inlay 24 is in the assembled state parallel to a main extension direction of the drawer unit 16.

Figure 6 shows a perspective bottom view of the further drawer unit 18. The drawer unit 16 has a base 12 configuration. The further drawer unit 18 differs from the drawer unit 16 in at least one geometrical parameter. The geometrical parameter of the drawer unit 16 is the connection interface 94. The geometrical parameter of the further drawer unit 18 is a further connection interface 96. The connection interface 94 is different from the further connection interface 96.

The further drawer unit 18 is configured to support two individually exchangeable further adapter inlays 26. The further adapter inlays 26 have identical dimensions aside from manufacturing tolerances and/or within the range of standardized tolerances.

The further drawer unit 18 with the base 12 configuration comprises one further connection interface 96. The further connection interface 96 is configured to support two base 12 further adapter inlays 26. The further connection interface 96 is configured to connect the further drawer unit 18 with the two base 12 further adapter inlays 26. The further connection surface 96 supports the base 12 adapter inlays 26 in the assembled state by means of a force-fit connection and/or by means of a form-fit connection. One base 12 further adapter inlay 26 comprises twelve LC simplex connections. One base 12 further adapter inlay 26 comprises six LC duplex connections. It is conceivable that the base 12 adapter inlay 26 comprises at least one SC connection and/or at least one MPO connection. It is conceivable that the base 12 further adapter inlay 26 comprises connections for a different kind of patch cables.

In the assembled state of the cable management unit 12 the base 12 adapter inlays 26 are arranged adjacent to each other. Respective main extension planes of respective base 12 further adapter inlays 26 are parallel to each other and/or are arranged in one same plane. Respective main extension planes of respective base 12 further adapter inlays 26 are parallel to the main extensions plane of the drawer unit 18. A main extension direction of the base 12 further adapter inlay 26 is in the assembled state parallel to a main extension direction of the further drawer unit 18.

The adapter inlay 24 and/or the further adapter inlay 26 and a part of the drawer unit 16 and/or of the further drawer unit 18 respectively implement at least partly a protective housing 56 for at least one further unit. The further unit may comprise at least one electronic component and/or a part of the at least one electronic component such as cable, in particular a patch cable, fiber connections, switches and/or microelectronic components. The protective housing 56 provides a dust protection. The protective housing 56 provides a protection against mechanical damage.

The cable management device 54 is assembled by means of a method for assembling the cable management device 54. The cable management system 10 is used to assemble the cable management device 54.

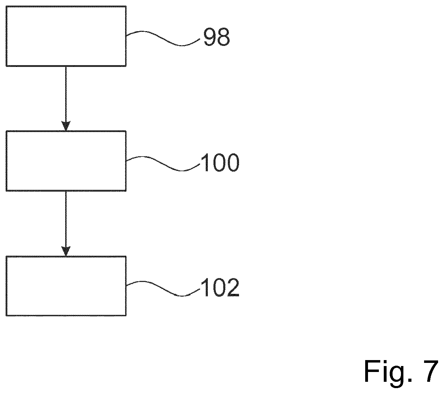

The method for assembling the cable management device 54 comprises a preparation step 98 (cf. figure 7). In the preparation step 98 the cable management unit 12 is assembled using the cable management system 10.

The method for assembling the cable management device 54 comprises an installation step 100. In the installation step 100 the cable management unit 12 is inserted into the network cabinet 58 and is fastened to the rack 60.

The method for assembling the cable management device 54 comprises a connection step 102. In the connection step 102 a patching process and a cable management process are performed.

### Reference numerals

- 10: cable management system
- 12: cable management unit
- 14: receiving space
- 16: drawer unit
- 18: further drawer unit
- 20: rear cable manager
- 22: rear side
- 24: adapter inlay
- 26: further adapter inlay
- 28: sensor unit
- 30: slide contact
- 32: corresponding slide contact
- 34: storage position
- 36: process position
- 38: front top cover unit
- 40: bi-stable living hinge
- 42: labelling surface
- 44: front cover unit
- 46: telescopic hinge
- 48: cable divider element
- 50: cable guiding channel
- 52: locking unit
- 54: cable management device
- 56: protective housing
- 58: network cabinet
- 60: rack
- 62: cables
- 64: carrier unit
- 66: frame unit
- 70: cover element
- 72: rear bracket
- 74: side bracket
- 76: mounting surface
- 78: main extension plane
- 80: main extension direction
- 82: mounting element
- 86: locking catch
- 88: lever
- 94: connection interface
- 96: further connection interface
- 98: preparation step
- 100: installation step
- 102: connection step

## Claims

1. A cable management system (10) comprising: at least one cable management unit (12) which has at least one receiving space (14) for receiving at least one drawer unit (16), wherein the cable management unit (12) comprises at least one rear cable manager (20), which is configured to feed at least one cable to a rear side (22) of the receiving space (14) and which is mountable in at least two different orientations with respect to the receiving space (14), **characterized in that** the rear cable manager (20) comprises at least one rear bracket (72) for rear cabling procedure, wherein the rear bracket (72) is mountable at at least two mounting positions over and under a main extension plane of the cable management unit (12).

2. The cable management system (10) according to claim 1, **characterized in that** it comprises the drawer unit (16) and at least one further drawer (18) unit differing from the drawer unit (16) in at least one geometrical parameter and fitting into the receiving space (14).

3. The cable management system (10) according to claim 2, **characterized in that** the drawer unit (16) has a base 8 configuration.

4. The cable management system (10) according to claim 3, **characterized in that** the drawer unit (16) is configured to support at least three individually exchangeable adapter inlays (24).

5. The cable management system (10) according to claim 2, **characterized in that** the further drawer unit (18) has a base 12 configuration.

6. The cable management system (10) according to claim 5, **characterized in that** the further drawer unit (18) is configured to support at least two individually exchangeable further adapter inlays (26).

7. The cable management system (10) according to claim, **characterized in that** the further drawer unit (18) has a base 12 configuration, the further drawer unit (18) is configured to support at least two individually exchangeable further adapter inlays (26), and **in that** the adapter inlay (24) and/or the further adapter inlay (26) and a part of the drawer unit (16) and/or of the further drawer unit (18) implement at least partly a protective housing (56) for at least one further unit.

8. The cable management system (10) according to any one of the preceding claims, **characterized by** at least one sensor unit (28), which has a plurality of sensors configured for detecting at least one connection state and which is arrangeable likewise on the drawer unit (16) and the further drawer unit (18).

9. The cable management system (10) according to claim 8, **characterized in that** the cable management unit (12) comprises at least one slide contact (30) configured to electrically connect the sensor unit (28) in at least one storage position (34) of the drawer unit (16) and/or the further drawer unit (18) and in at least one process position (36) of the drawer unit (16) and/or the further drawer unit (18).

10. The cable management system (10) according to any one of the preceding claims, **characterized in that** the drawer unit (16) and/or the further drawer unit (18) comprise/comprises a front top cover unit (38), which is located in a front area of the cable management unit (12) and is configured to protect at least one cable from above.

11. The cable management system (10) according to claim 10, **characterized in that** the front top cover unit (38) comprises a bi-stable living hinge (40).

12. The cable management system (10) according to claim 10 or 11, **characterized in that** the front top cover unit (38) comprises at least one labelling surface (42).

13. The cable management system (10) according to any one of the preceding claims, **characterized in that** the cable management unit (12) comprises at least one front cover unit (44) that is configured for covering the receiving space (14) in a forward direction and has at least one telescopic hinge (46).

14. The cable management system (10) according to any one of the preceding claims, **characterized in that** the drawer unit (16) and/or the further drawer unit (18) comprise/comprises at least one cable divider element (48) which, in an assembled state, defines at least two cable guiding channels (50) and is positioned in a front area of the cable management unit (12).

15. The cable management system (10) according to any one of the preceding claims, **characterized in that** the cable management unit (12) comprises a locking unit (52) configured to lock the drawer unit (16) and/or the further drawer unit (18) at least in a storage position (34) and/or in a process position (36).

16. A cable management device (54) comprising at least a cable management system (10) according to any one of the preceding claims.

17. A method for assembling a cable management device (54) according to claim 16.

## Patentansprüche

1. Kabelmanagementsystem (10), aufweisend:
mindestens eine Kabelmanagementeinheit (12), die zumindest einen Aufnahmeraum (14) zu einer Aufnahme mindestens einer Schubladeneinheit (16) aufweist,
wobei die Kabelmanagementeinheit (12) zumindest einen hinteren Kabelmanager (20) umfasst, der dazu vorgesehen ist, mindestens ein Kabel einer Rückseite (22) des Aufnahmeraums (14) zuzuführen, und der in mindestens zwei verschiedenen Ausrichtungen relativ zu dem Aufnahmeraum (14) montierbar ist,
**dadurch gekennzeichnet, dass** der hintere Kabelmanager (20) für einen rückwärtigen Verkabelungsvorgang mindestens einen hinteren Bügel (72) aufweist, wobei der hintere Bügel (72) in mindestens zwei Montagepositionen oberhalb und unterhalb einer Haupterstreckungsebene der Kabelmanagementeinheit (12) anbringbar ist.

2. Kabelmanagementsystem (10) nach Anspruch 1,
**dadurch gekennzeichnet, dass** es die Schubladeneinheit (16) sowie zumindest eine weitere Schubladeneinheit (18) aufweist, die sich in mindestens einem geometrischen Parameter von der Schubladeneinheit (16) unterscheidet und die in den Aufnahmeraum (14) passt.

3. Kabelmanagementsystem (10) nach Anspruch 2,
**dadurch gekennzeichnet, dass** die Schubladeneinheit (16) eine Basis-8-Konfiguration aufweist.

4. Kabelmanagementsystem (10) nach Anspruch 3,
**dadurch gekennzeichnet, dass** die Schubladeneinheit (16) dazu vorgesehen ist, mindestens drei separat austauschbare Adapterinlays (24) zu lagern.

5. Kabelmanagementsystem (10) nach Anspruch 2,
**dadurch gekennzeichnet, dass** die weitere Schubladeneinheit (18) eine Basis-12-Konfiguration aufweist.

6. Kabelmanagementsystem (10) nach Anspruch 5,
**dadurch gekennzeichnet, dass** die weitere Schubladeneinheit (18) dazu vorgesehen ist, mindestens zwei separat austauschbare weitere Adapterinlays (26) zu lagern.

7. Kabelmanagementsystem (10) nach Anspruch 4,
**dadurch gekennzeichnet, dass** die weitere Schubladeneinheit (18) eine Basis-12-Konfiguration aufweist, dass die weitere Schubladeneinheit (18) dazu vorgesehen ist, mindestens zwei separat austauschbare weitere Adapterinlays zu lagern, und dass das Adapterinlay (24) und/oder das weitere Adapterinlay (26) sowie ein Teil der Schubladeneinheit (16) und/oder der weiteren Schubladeneinheit (18) zumindest teilweise ein Schutzgehäuse (56) für mindestens eine weitere Einheit ausbilden.

8. Kabelmanagementsystem (10) nach einem der vorhergehenden Ansprüche, **gekennzeichnet durch** mindestens eine Sensoreinheit (28), die eine Vielzahl zur Erfassung mindestens eines Verbindungszustands vorgesehener Sensoren aufweist und die an der Schubladeneinheit (16) ebenso wie an der weiteren Schubladeneinheit (18) anordenbar ist.

9. Kabelmanagementsystem (10) nach Anspruch 8,
**dadurch gekennzeichnet, dass** die Kabelmanagementeinheit (12) mindestens einen Gleitkontakt (30) aufweist, der dazu vorgesehen ist, in mindestens einer Lagerungsstellung (34) der Schubladeneinheit (16) und/oder der weiteren Schubladeneinheit (18) und in mindestens einer Betätigungsstellung (36) der Schubladeneinheit und/oder der weiteren Schubladeneinheit (18) die Sensoreinheit (28) elektrisch anzubinden.

10. Kabelmanagementsystem (10) nach einem der vorhergehenden Ansprüche, **dadurch gekennzeichnet, dass** die Schubladeneinheit (16) und/oder die weitere Schubladeneinheit (18) eine vordere obere Abdeckeinheit (38) aufweisen/aufweist, welche in einem vorderen Bereich der Kabelmanagementeinheit (12) angeordnet ist und dazu vorgesehen ist, mindestens ein Kabel von oben zu schützen.

11. Kabelmanagementsystem (10) nach Anspruch 10,
**dadurch gekennzeichnet, dass** die vordere obere Abdeckeinheit (38) ein bistabiles Filmscharnier (40) aufweist.

12. Kabelmanagementsystem (10) nach Anspruch 10 oder 11,
**dadurch gekennzeichnet, dass** die vordere obere Abdeckeinheit (38) mindestens eine Etikettierfläche (42) aufweist.

13. Kabelmanagementsystem (10) nach einem der vorhergehenden Ansprüche, **dadurch gekennzeichnet, dass** die Kabelmanagementeinheit (12) mindestens eine vordere Abdeckeinheit (44) aufweist, die dazu vorgesehen ist, den Aufnahmeraum (14) nach vorne abzudecken, und die mindestens ein Teleskopscharnier (46) aufweist.

14. Kabelmanagementsystem (10) nach einem der vorhergehenden Ansprüche, **dadurch gekennzeichnet, dass** die Schubladeneinheit (16) und/oder die weitere Schubladeneinheit (18) mindestens ein Kabelteilerelement (48) aufweisen/aufweist, welches in einem montierten Zustand mindestens zwei Kabelführungskanäle (50) definiert und in einem vorderen Bereich der Kabelmanagementeinheit (12) positioniert ist.

15. Kabelmanagementsystem (10) nach einem der vorhergehenden Ansprüche,
**dadurch gekennzeichnet, dass** die Kabelmanagementeinheit (12) eine Verriegelungseinheit (52) aufweist, die zu einer Verriegelung der Schubladeneinheit (16) und/oder der weiteren Schubladeneinheit (18) zumindest in einer Lagerungsstellung (34) und/oder in einer Betätigungsstellung (36) vorgesehen ist.

16. Kabelmanagementvorrichtung (54), die mindestens ein
Kabelmanagementsystem (10) nach einem der vorhergehenden Ansprüche aufweist.

17. Verfahren zur Montage einer Kabelmanagementvorrichtung (54) nach Anspruch 16.

## Revendications

1. Système de gestion de câbles (10), comprenant :
au moins une unité de gestion de câbles (12) ayant au moins un espace de logement (14) pour loger au moins une unité tiroir (16),
l'unité de gestion de câbles (12) comprenant au moins un organisateur câble arrière (20), qui est prévu pour alimenter au moins un câble à une face arrière (22) de l'espace de logement (14) et qui peut être monté en au moins deux orientations différentes par rapport à l'espace de logement,
**caractérisé en ce que**
l'organisateur câble arrière (20) comprend au moins un étrier arrière (72) pour un procès de câblage arrière, l'étrier arrière (20) étant montable dans au moins deux positions de montage au-dessus et au-dessous d'un plan d'étendue principale de l'unité de gestion de câbles (12).

2. Système de gestion de câbles (10) selon la revendication 1,
**caractérisé en ce qu'**il comprend l'unité tiroir (16) et au moins une autre unité tiroir (18) qui diffère de l'unité tiroir (16) en au moins un paramètre géométrique et qui tient dans l'espace de logement (14).

3. Système de gestion de câbles (10) selon la revendication 2,
**caractérisé en ce que** l'unité tiroir (16) a une configuration base-8.

4. Système de gestion de câbles (10) selon la revendication 3,
**caractérisé en ce que** l'unité tiroir (16) est prévue pour supporter au moins trois inserts d'adaptateur (24) qui sont échangeables individuellement.

5. Système de gestion de câbles (10) selon la revendication 2,
**caractérisé en ce que** l'autre unité tiroir (18) a une configuration base-12.

6. Système de gestion de câbles (10) selon la revendication 5,
**caractérisé en ce que** l'autre unité tiroir (18) est prévue pour supporter au moins deux autres inserts d'adaptateur (26) qui sont échangeables individuellement.

7. Système de gestion de câbles (10) selon la revendication 4,
**caractérisé en ce que** l'autre unité tiroir (18) a une configuration base-12, que l'autre unité tiroir (18) est prévue pour supporter au moins deux autres inserts d'adaptateur (26) qui sont échangeables individuellement et que l'insert d'adaptateur (24) et/ou l'autre insert d'adaptateur (26) et une partie de l'unité tiroir (16) et/ou de l'autre unité tiroir (18) réalisent au moins partiellement un boîtier protectif (56) pour au moins une autre unité.

8. Système de gestion de câbles (10) selon l'une des revendications précédentes,
**caractérisé par** au moins une unité de captage (28) qui comporte une pluralité de capteurs prévus pour détecter au moins un état de raccordement et qui peut être disposée pareillement sur l'unité tiroir (16) et sur l'autre unité tiroir (18).

9. Système de gestion de câbles (10) selon la revendication 8,
**caractérisé en ce que** l'unité de gestion de câbles (12) comprend au moins un contact glissant (30) prévu pour électriquement raccorder l'unité de captage (28) dans au moins une position de rangement (34) de l'unité tiroir (16) et/ou de l'autre unité tiroir (18) et dans au moins une position de maniement (36) de l'unité tiroir (16) et/ou de l'autre unité tiroir (18).

10. Système de gestion de câbles (10) selon l'une des revendications précédentes,
**caractérisé en ce que** l'unité tiroir (16) et/ou l'autre unité tiroir (18) comprennent/comprend une unité de couverture supérieure d'avant (38) localisée dans une zone frontale de l'unité de gestion de câbles (12) et prévue pour protéger au moins un câble d'en haut.

11. Système de gestion de câbles (10) selon la revendication 10,
**caractérisé en ce que** l'unité de couverture supérieure d'avant (38) comprend une charnière-film bistable (40).

12. Système de gestion de câbles (10) selon la revendication 10 ou 11,
**caractérisé en ce que** l'unité de couverture supérieure d'avant (38) comprend au moins une surface d'étiquetage (42).

13. Système de gestion de câbles (10) selon l'une des revendications précédentes,
**caractérisé en ce que** l'unité de gestion de câbles (12) comprend au moins une unité de couverture antérieure (44) qui est prévue pour couvrir l'espace de logement (14) vers l'avant et comporte au moins une charnière télescopique (46).

14. Système de gestion de câbles (10) selon l'une des revendications précédentes,
**caractérisé en ce que** l'unité tiroir (16) et/ou l'autre unité tiroir (18) comprennent/comprend au moins un élément séparateur de câbles (48) qui, en état monté, définit au moins deux conduits-guidage de câbles (50) et est positionné dans une zone frontale de l'unité de gestion de câbles (12).

15. Système de gestion de câbles (10) selon l'une des revendications précédentes,
**caractérisé en ce que** l'unité de gestion de câbles (12) comprend une unité de verrouillage (52) prévue pour verrouiller l'unité tiroir (16) et/ou l'autre unité tiroir (18) au moins dans une position de rangement (34) et/ou dans une position de maniement (36).

16. Dispositif de gestion de câbles (54) comprenant au moins un système de gestion de câbles (10) selon l'une des revendications précédentes.

17. Procédé pour le montage d'un dispositif de gestion de câbles (54) selon la revendication 16.
